# EUROPEAN PATENT APPLICATION

(11) **EP 2 924 710 A1**
(43) Date of publication of application: **30.09.2015**
(21) Application number: 14161519.5
(22) Date of filing: 25.03.2014
(51) Int. Cl.: H01J 37/28, H01J 37/30

(54) **Imaging a sample with multiple beams and a single detector**

(71) Applicant: FEI COMPANY, Hillsboro, Oregon 97124-5793 (US)
(72) Inventor: Potocek, Pavel, 5654 PX Eindhoven (NL); Kooijman, Cornelis, 5501 BC Veldhoven (NL); Slingerland, Hendrik, 5912 TW Venlo (NL); Veen, van, Gerard, 5581 HB Waalre (NL); Boughorbel, Faysal, 5629 GA Eindhoven (NL); Faber, Pybe, 5627 KH Eindhoven (NL)
(74) Representative: Bakker, Hendrik

(57) **Abstract**

The invention relates to a multi-beam apparatus (210) for inspecting a sample (232) with at least a first focused beam and a second focused beam, the apparatus equipped to scan the first and the second beam (243, 218) over the sample, the apparatus equipped with at least one detector (240) for detecting secondary radiation emitted by the sample when said sample is irradiated by the first and the second beam, the detector capable of outputting a detector signal representing the intensity of the secondary radiation detected by the detector, in working the detector signal comprising information caused by the first and the second beam, **characterized in that** the apparatus is equipped with a programmable controller (219) programmed for processing the detector signal using a source separation technique, as a result of which the programmable controller is equipped to output a signal representing information caused by a single beam.

## Description

### Technical field of the invention

The invention relates to a multi-beam apparatus for inspecting a sample with at least a first focused beam and a second focused beam, the apparatus equipped to scan the first and the second beam over the sample, the apparatus equipped with at least one detector for detecting secondary radiation emitted by the sample when said sample is irradiated by the first and the second beam, the detector capable of outputting a detector signal representing the intensity of the secondary radiation detected by the detector, in working the detector signal comprising information caused by the first and the second beam.

The invention further relates to a method using such an apparatus.

### Background of the invention

Such a multi-beam apparatus is known, for example, as a DualBeam™ instrument commercially available from FEI Company, Hillsboro, USA.

In a DualBeam™ instrument an ion beam column producing an ion beam and an electron beam column producing an electron beam are placed such, that the two beams intersect at the sample position. Each beam can be scanned independently over the sample. For imaging a detector is used that detects secondary electrons (SEs) and/or backscattered electrons (BSEs). The SEs and BSEs are emitted by the sample in response to the impinging electrons and ions. SEs are defined as electrons emitted by the sample with an energy of less than 50 eV, while BSEs are emitted with an energy in excess of 50 eV.

Using the apparatus in so-called SPI mode implies simultaneous milling with the ion beam and imaging with the electron beam. A problem arises in that the detector cannot determine which beam is the cause of what signal, as it is only capable of detecting a combination of the signal caused by the first beam and the second beam. This is also called cross-talk of the signals.

In lecture notes of an application course given 2009-03-24 - 2009-03-26 by Dr. Chengge Jiao, (FEI Company), published as http://www.nanophys.kth.se/nanophys/facilities/nfl/fei-nova200/appl-course/course-v3.html,[-1-] it is mentioned that "preferably Isem>>lion, and that for example 30 pA ion beam and 1.6 nA ebeam SPI works well".

The reason for this is that each impacting ion produces approximately twice as many secondary electrons as an impacting electron. By using an electron beam current that is much larger than the ion beam current the signal caused by the ion beam is made negligible.

This is also explained in for example "Characterisation of focused ion beam nanostructures by transmission electron microscopy", Susan B. Turnbull M.Sci, presented as a thesis for the degree of Ph.D. at the Department of Physics and Astronomy, University of Glasgow, September 2008, further referred to as Turnbull [-2-], more specifically in chapter 2: Instrumentation and experimental techniques (page 42): "This particular model of dual beam FIB has 2 modes for electron imaging. Mode 1 or search mode is for general imaging and can be used simultaneously with the ion beam to provide live imaging of the patterning process. Whilst both the SEM and FIB generate secondary electrons, the secondary electron yield per primary electron for FIB is roughly double that for the SEM. This means that the electron beam current must be larger than the ion beam current so that it may be detected above the FIB induced signal."

A disadvantage of this method is that the electron beam current must be much larger than the ion beam current to make the effect of the ion beam current negligible by making the signal of the electron beam much larger than the signal of the ion beam. It is mentioned that preferably also averaging is used to eliminate the "interference" (cross-talk) of the ion beam's signal to the electron beam's signal.

It is noted that in the context of the invention 'a signal' includes both an (analogue) electric signal and the digitized representation thereof as formed by an A/D convertor.

In "Multi-beam confocal microscopy based on a custom image sensor with focal-plane pinhole array effect", K. Kagawa et al., Optics Express Vol. 21 No. 2 (Jan. 2013), p. 1417 - 1429, further referred to as Kagawa [-3-] a multi-beam confocal microscope is disclosed in which a sample is illuminated by multiple optical beams. The beams are scanned over the sample by scanning mirrors. Each illuminated position of the sample is imaged on a pixel of a position sensitive sensor (a CMOS sensor). This sensor thus acts as multiple detectors discriminating between the multiple images, each image associated with one beam, and thus no cross-talk arises.

A disadvantage of this method is that it requires an imaging system between sample and sensor, resulting in added costs and added space restrictions.

The Auriga brochure as available on the internet, further referred to as [-4-], describes the Auriga™, an apparatus commercially available from Carl Zeiss NTS Gmbh, Oberkochen, Germany uses an ion beam and an electron beam irradiating the sample simultaneously. The ion beam and the electron beam both generate backscattered electrons, but due to the inefficient momentum transfer the maximum energy of electrons generated by the ion beam is much less than the backscattered electrons generated by the electron beam. The EsB detector described at page 20 of the brochure [-4-] only detects backscattered electrons with an energy higher than the BSE's generated by the ion beam, and thus the signal of the detector comprises information of one beam only. A disadvantage of this solution is that it demands a more elaborate detector, resulting in extra costs and the usage of extra space.

In US patent No. US7,385,165B2 to Nikon another multi-beam scanning microscope is discussed, in which each beam has an associated detector (column 2, line 31: "In the case of a multi-beam type microscope, a photoelectric detector 11 is installed for each beam"). A disadvantage of this solution is that an imaging system is needed imaging the sample on the detectors, and multiple detectors.

The invention intends to offer a solution to said disadvantages.

### Summary of the invention

To that end the apparatus is **characterized in that** the apparatus is equipped with a programmable controller programmed for processing the detector signal using a source separation technique, as a result of which the programmable controller is equipped to output a signal representing information caused by a single beam.

Inventors realized that an apparatus with at least as many detectors as beams can be described as a mathematically well determined or even an over-determined problem. However, when the number of beams is larger than the number of detectors, the problem cannot be solved as an (over-)determined system. However, if extra knowledge of the signals is available, for example by spatial-temporal modulation (e.g. repetitive intensity modulation or blanking of at least one beam, or blanking of at least one beam), by knowledge of overlapping scan areas, scan rated, etc., the problem can become a solvable problem.

If one of the beams is repetitively blanked, the contribution of the other beam to the signal can be determined on a regular basis. The other signal, although repetitively blanked, can still be used to make a good image, for example using sparse scanning techniques.

If the two beams scan overlapping areas but at different scan rates, source separation techniques (preferably blind source separation) and/or pattern recognition can distinguish the two signals as for the overlapping area some resemblance of both signals occurs.

If one of the beams scans much faster than the other, a low pass/high pass filtering can unravel the two signals.

In a preferred embodiment the controller outputs a signal representing information caused by the first beam and a signal representing information caused by the second beam.

In an embodiment of the invention the beams are beams from the group of photon beams, charged particle beams, ion beams and electron beams, or combinations thereof.

The use of two ion beams occurs when an plasma source is used producing more than one type of ions (for example two elements, such as He and Ar,), or a Liquid Metal Ion Source (LMIS) producing multiple elements (for example silicon and gold), or a beam with single or double charged ions, or a LMIS producing two isotopes (for example ⁶⁹Ga and ⁷¹Ga).

The use of an electron beam and an ion beam occurs in for example a DualBeam™ to which a programmable controller, for example in the form of a computer, is added for performing the source separation method.

The combination of a light beam and an electron beam may occur when fluorescent optical microscopy is combined with Scanning Transmission Electron Microscopy, also resulting in fluorescence.

The secondary radiation generated by the beams may comprise secondary radiation from the group of photons, X-rays, secondary electrons, backscattered electrons, and secondary ions.

In an aspect of the invention a method for inspecting a sample with a multi-beam apparatus, the apparatus scanning at least a first and a second beam over the sample, the sample in response to the irradiation with the beams emitting secondary radiation, the secondary radiation detected by a detectors, the detectors outputting a detector signal representing the intensity of the secondary radiation detected by the detector, the signal of the detector comprises information caused by both beams, **is characterized in that** the information caused by the first beam is reconstructed from the detector signal by a programmable controller programmed to process the detector signal using a source separation technique.

In an embodiment of the method the source separation technique relies at least in part on spatial-temporal modulation, including beam blanking or beam intensity modulation or known differences in scan time or differences in scan area.

By modulating the intensity of one of the beam, for example by temporary blanking (or intensity modulated) of one beam, the effect of the other beam can be determined.

Differences in scan time occur when one beam is scanned by one scan unit (optical, electrostatic or magnetic) at another frame rate than the other beam. The difference in frame rate can be the result of different dwell times per pixel, or by different number of pixels for the different beams.

Differences of scan area occur when two beams are scanned by different scan units, but may also occur when different ions (different elements, isotopes or single charged versus double charged ions) are deflected by one magnetic scan unit or due to stray magnetic fields influencing these different ions.

In another embodiment of the method the first and the second beam are beams from the group of a photon beam, a charged particle beam, an ion beam and an electron beam, or combinations thereof.

In yet another embodiment of the method the first and the second beam are two ion beams, the ions in the first beam having a different mass-to-charge ration than the second beam.

In still another embodiment of the method the first and the second beam are formed by one ion source and are deflected over the sample by one deflection unit.

In another embodiment of the method the secondary radiation comprises visible light photons, UV photons, X-ray photons, secondary electrons, backscattered electrons, and combinations thereof.

In another embodiment of the method the first beam scans a first area and the second beam scans a second area, the first area and the second area showing overlap.

It is noted that the signal of another detector may be used to improve the reconstruction. Using a DualBeam™ apparatus, the SE image (SEs are secondary electrons with an energy of less than 50 eV) of the Scanning Electron Microscope (SEM) column typically shows a high resolution. The ion beam column also causes the generation of SEs), but will not or hardly generate high energy BSEs (secondary electrons with an energy of more than 50 eV. The SEM column does generate BSEs, and the signal of a BSE detector can thus be used to improve the reconstruction of the SE image.

In a generalized version this invention can be used to image a sample with N beams and using M detectors, where M < N.

It is noted that, when using more than two beams and blanking or intensity modulating part of the beams, this may be handled alike a coded aperture problem and can be solved in that way.

Applicant also seeks protection for a software carrier carrying software for programming the controller of the apparatus to perform any of the methods according to the invention.

### Brief description of the drawings

The invention is elucidated using figures, in which identical reference numerals refer to corresponding features. To that end:
Figure 1 schematically shows a dual beam instrument,
Figure 2 schematically shows how to differentiate/disentangle a compound signal So with a high frequency component S₁ caused by one beam and a low frequency component S₂ caused by another beam.
Figure 3 shows a signal with periodic blanking of one of the beams.

### Detailed description of preferred embodiments

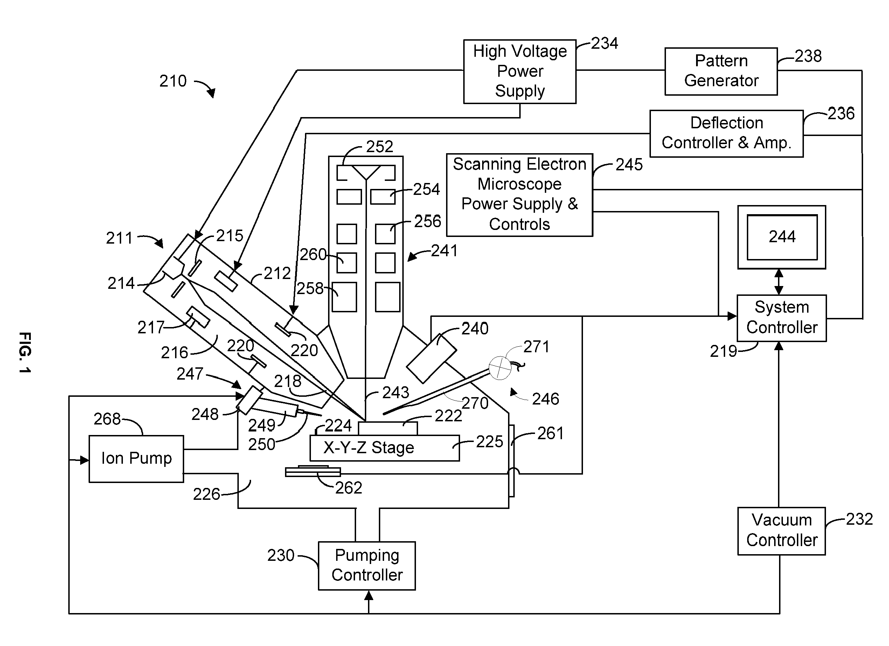

FIG. 1 depicts one embodiment of an exemplary dual beam SEM/FIB system 210 that is equipped to carry out a method according to the present invention.

Dual beam system 210 has a vertically mounted electron beam column and a focused ion beam (FIB) column mounted at an angle of approximately 52 degrees from the vertical on an evacuable specimen chamber 226. The specimen chamber may be evacuated by e.g. a turbo-molecular pump, or other known pumping means such as oil diffusion pumps, ion getter pumps, scroll pumps, etc.

The electron beam column 241 comprises an electron source 252 for producing electrons and electron-optical lenses 256, 258 forming a finely focused beam of electrons 243. The beam of electrons 243 can be positioned on and can be scanned over the surface of a substrate 222 by means of a deflection coil 260. Operation of lenses 256, 258 and deflection coil 260 is controlled by power supply and control unit 245. It is noted that lenses and deflection unit may use electric fields to manipulate the electron beam, or that magnetic fields may be used, or a combination thereof.

Electron beam 243 can be focused onto substrate 222, which is on movable X-Y-Z stage 225 within lower chamber 226.

Mounted on the vacuum chamber is a Gas Injection System (GIS) 246. The GIS comprises a reservoir (not shown) for holding the precursor material and a needle 270 for directing the precursor material to the surface of the substrate. The GIS further comprises means 271 for regulating the supply of precursor material to the substrate. In this example the regulating means are depicted as an adjustable valve, but the regulating means may also take the form of e.g. controlled heating of the precursor material.

When the electrons in the electron beam strike substrate 222, secondary electrons are emitted. These secondary electrons are detected by secondary electron detector 240, such as an Everhard-Thornley detector, or a semiconductor device capable of detecting low energy electrons. The signal of the detector is fed to a controller 219. Said controller also controls the deflector signals, lenses, electron source, GIS, stage and pump, and other items of the instrument. Monitor 244 is used to display an image of the substrate using the signal of the controller 219. STEM detector 262, located beneath the TEM sample holder 224 and the stage 225, can collect electrons that are transmitted through a sample mounted on the TEM sample holder.

Dual beam system 210 also includes focused ion beam (FIB) system 211 which comprises an evacuated chamber having an upper neck portion 212 within which are located an ion source 214 and a focusing column 216 including extractor electrodes and an electrostatic optical system. The axis of focusing column 216 is tilted 52 degrees from the axis of the electron column. The ion column 212 includes an ion source 214, such as a Liquid Metal Ion Source (LMIS) producing a mono-isotopic beam of ions of gallium, an extraction electrode 215, a focusing element 217, deflection elements 220, and a focused ion beam 218. Ion beam 218 passes from ion source 214 through column 216 and between electrostatic deflection means schematically indicated at 220 toward substrate 222, which comprises, for example, a semiconductor device positioned on movable X-Y-Z stage 225 within lower chamber 226.

Stage 225 can also support one or more TEM sample holders 224 so that a sample can be extracted from the semiconductor device and moved to a TEM sample holder. Stage 225 can preferably move in a horizontal plane (X and Y axes) and vertically (Z axis). Stage 225 can also tilt approximately sixty (60) degrees and rotate about the Z axis. In some embodiments, a separate TEM sample stage (not shown) can be used. Such a TEM sample stage will also preferably be moveable in the X, Y, and Z axes. A door 261 is opened for inserting substrate 222 onto X-Y-Z stage 225 and also for servicing an internal gas supply reservoir, if one is used. The door is interlocked so that it cannot be opened if the system is under vacuum.

An ion pump 268 is employed for evacuating neck portion 212. The chamber 226 is evacuated with turbomolecular and mechanical pumping system 230 under the control of vacuum controller 232. The vacuum system provides within chamber 226 a vacuum of approximately 3 x 10⁻⁶ mbar. When a suitable precursor gas is introduced onto the sample surface, the chamber background pressure may rise, typically to about 5 x 10⁻⁵ mbar.

High voltage power supply 234 is connected to liquid metal ion source 214 as well as to appropriate electrodes in ion beam focusing column 216 for forming an approximately 1 keV to 60 keV ion beam 218 and directing the same toward a sample. Deflection controller and amplifier 236, operated in accordance with a prescribed pattern provided by pattern generator 238, is coupled to deflection plates 220 whereby ion beam 218 may be controlled manually or automatically to trace out a corresponding pattern on the upper surface of substrate 222. In some systems the deflection plates are placed before the final lens, as is well known in the art. Beam blanking electrodes (not shown) within ion beam focusing column 216 cause ion beam 218 to impact onto blanking aperture (not shown) instead of substrate 222 when a blanking controller (not shown) applies a blanking voltage to the blanking electrode.

The liquid metal ion source 214 typically provides a metal ion beam of gallium. The source typically is capable of being focused into a sub one-tenth micrometer wide beam at substrate 222 for either modifying the substrate 222 by ion milling, enhanced etch, material deposition, or for the purpose of imaging the substrate 222.

A micromanipulator 247, such as the AutoProbe 200™ from Omniprobe, Inc., Dallas, Texas, or the Model MM3A from Kleindiek Nanotechnik, Reutlingen, Germany, can precisely move objects within the vacuum chamber. Micromanipulator 247 may comprise precision electric motors 248 positioned outside the vacuum chamber to provide X, Y, Z, and theta control of a portion 249 positioned within the vacuum chamber. The micromanipulator 247 can be fitted with different end effectors for manipulating small objects. In the embodiments described herein, the end effector is a thin probe 250. As is known in the prior art, a micromanipulator (or microprobe) can be used to transfer a TEM sample (which has been freed from a substrate, typically by an ion beam) to a TEM sample holder for analysis.

A system controller 219 controls the operations of the various parts of dual beam system 210. Through system controller 219, a user can cause ion beam 218 or electron beam 243 to be scanned in a desired manner through commands entered into a conventional user interface (not shown). Alternatively, system controller 219 may control dual beam system 210 in accordance with programmed instructions.

The apparatus 210 is thus an apparatus with two beams and often uses only one detector for the image shown at monitor 244, the detector for example the Everhard-Thornley detector 240, or a SiPMT, or another detector capable of detecting secondary electrons (electrons with an energy of less than 50 eV).

The FIB typically scans with a much higher scan rate (frame rate) than the e-beam column. Assuming the frame rate of the FIB is T₁ and the frame rate of the electron beam column T₂, this results in a signal with a repetition rate of T₂ with superimposed a signal with a repetition rate of T₁.

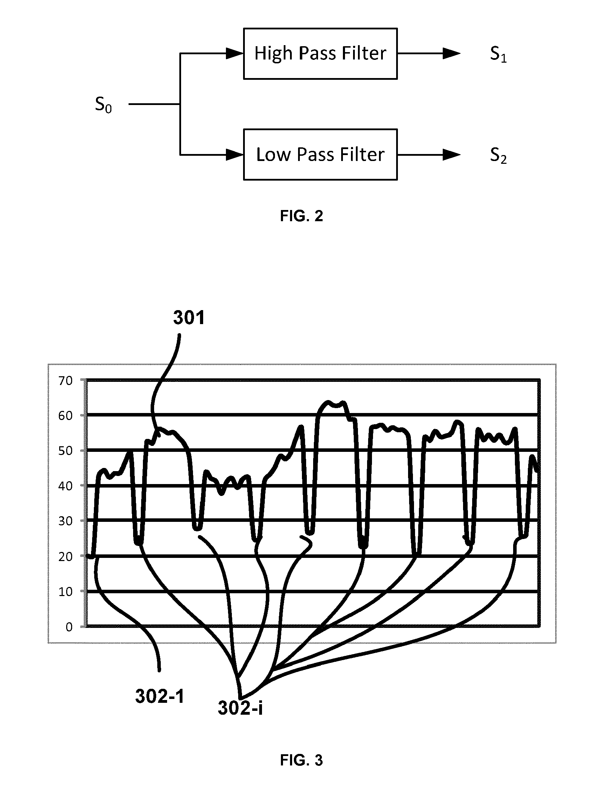

Figure 2 schematically shows how to differentiate/disentangle a compound signal So with a high frequency component S₁ caused by one beam and a low frequency component S₂ caused by another beam.

By using a high pass filter and a low-pass filter, either in the form of analogue filters or, after an A/D conversion, as digital filters, the signals can be disentangled. It is noted that 'a signal' includes in the context of the invention both an (analogue) electric signal and the digitized representation thereof as formed by an A/D convertor.

This method is particularly useful when for example both beams scan the sample and the line time of the fast signal is equal to or shorter than the pixel time of the slow signal. The line scans of the fast signal will more or less repeat themselves after each line, as the difference between lines is not too large.

Figure 3 schematically shows a signal in which one of the beams is blanked on a regular basis.

The signal 301 comprises information caused by two beams, in which one of the beams is blanked at moments T1 ... T9. This results in a temporary lowering of the signal 301, as the contribution of the temporarily blanked beam is temporarily zero.

In this example one of the beams is only momentarily blanked, but it is also attractive to blank the beam for a line time of the other beam.

It is noted that when the scan signal of the beam that is blanked part of the time is running continuously, not all parts of the sample are irradiated by the beam that is blanked part of the time. This may be solved by treating the problem as a "sparse sampling" problem to reconstruct a complete image.

It is further noted that when one of the signals is much faster than the other, the temporarily blanking can easily result in a splitting of the signals.

It is noted that stray magnetic fields acting on a beam comprising ions with different mass-to-charge ratios to be split into two beams irradiating different parts of the sample, and is thus a problem addressed in this invention.

### Cited non-patent literature

[-1-] "Application course", Dr. Chengge Jiao, (FEI Company), presented 2009-03-24-2009-03-26, published as http://www.nanophys.kth.se/nanophys/facilities/nfl/feinova200/appl-course/course-v3.html
[-2-] "Characterisation of focused ion beam nanostructures by transmission electron microscopy", S. Turnbull, presented as a thesis for the degree of Ph.D. at the Department of Physics and Astronomy, University of Glasgow, September 2008.
[-3-] "Multi-beam confocal microscopy based on a custom image sensor with focal-plane pinhole array effect", K. Kagawa et al., Optics Express Vol. 21 No 2 (Jan 2013), p 1417-1429.
[-4-] Auriga brochure, published on the internet http://applications.zeiss.com/C125792900358A3F/0/3844B32905D07251C1257951004782A E/$FILE/AURIGA Brochure.pdf, last modified 29-5-2012.

## Claims

1. A multi-beam apparatus (210) for inspecting a sample (222) with at least a first focused beam (243) and a second focused beam (218), the apparatus equipped to scan the first and the second beam over the sample, the apparatus equipped with at least one detector (240) for detecting secondary radiation emitted by the sample when said sample is irradiated by the first and the second beam, the detector capable of outputting a detector signal representing the intensity of the secondary radiation detected by the detector, in working the detector signal comprising information caused by the first and the second beam, **characterized in that** the apparatus is equipped with a programmable controller (219) programmed for processing the detector signal using a source separation technique, as a result of which the programmable controller is equipped to output a signal representing information caused by a single beam.

2. The multi-beam apparatus of claim 1 in which the controller (219) is equipped to output a signal representing information caused by the first beam (243) and a signal representing information caused by the second beam (218).

3. The apparatus of any of the preceding claims in which the beams (218, 243) are beams from the group of photon beams, charged particle beams, ion beams and electron beams, or combinations thereof.

4. The apparatus of claim 3 in which the first beam (243) is a beam of electrons and the second beam (218) is a beam of ion, or vice versa.

5. The apparatus of claim 3 in which the first beam and the second beam are beams of ions, the ions of the first beam showing a different charge-to-mass ratio than the ions of the second beam.

6. The apparatus of claim 5 in which the apparatus is equipped with an ion source, the ion source producing the ions of the first beam and the second beam.

7. The apparatus of any of the preceding claims in which the detector (240) is equipped to detect visible light photons, UV photons, X-ray photons, secondary electrons, backscattered electrons, and/or combinations thereof.

8. A method for inspecting a sample (222) with a multi-beam apparatus, the apparatus scanning at least two focused beams (243, 218) over the sample, the sample in response to the irradiation with the beams emitting secondary radiation, the secondary radiation detected by a detectors (240), the detectors outputting a detector signal representing the intensity of the secondary radiation detected by the detector, the signal of the detector comprises information caused by both beams, **characterized in that** the information caused by one beam is reconstructed from the detector signal by a programmable controller (219) programmed to process the detector signal using a source separation technique.

9. The method of claim 8 in which the source separation technique relies at least in part on spatial-temporal modulation, including beam blanking or beam intensity modulation or known differences in scan time or differences in scan area.

10. The method of any of claims 8 - 9 in which the at least two beams (243, 218) are beams from the group of a photon beam, a charged particle beam, an ion beam and an electron beam, or combinations thereof.

11. The method of claim 10 in which the at least two beams are two ion beams, the ions in the first beam having a different mass-to-charge ration than the second beam.

12. The method of claim 10 in which the at least two ion beams are formed by one ion source and are deflected over the sample by one deflection unit.

13. The method of any of claims 8 - 12 in which the secondary radiation comprises visible light photons, UV photons, X-ray photons, secondary electrons, backscattered electrons, and combinations thereof.

14. The method of any of claims 8 - 13 in which the first beam (243) scans a first area, the second beam (218) scans a second area, and the first area and the second area show overlap.

15. Software carrier for programming the programmable processor (219) of any of claims 1- 7 to perform any of the methods of claims 8 - 14.
